# EUROPÄISCHE PATENTANMELDUNG

(11) **EP 4 372 799 A1**
(43) Veröffentlichungstag der Anmeldung: **22.05.2024**
(21) Anmeldenummer: 22207538.4
(22) Anmeldetag: 15.11.2022
(51) Int. Cl.: H01L 23/00, H05K 3/32, H05K 3/40

(54) **ANBINDUNG EINES HALBLEITERELEMENTS AN EIN SUBSTRAT**

(71) Anmelder: NanoWired GmbH, 64579 Gernsheim (DE)
(72) Erfinder: BIRLEM, Olav, 64579 Gernsheim (DE); QUEDNAU, Sebastian, 64579 Gernsheim (DE); WEISSENBORN, Florian, 64579 Gernsheim (DE); BAYER, Christoph Friedrich, 64579 Gernsheim (DE)
(74) Vertreter: Schwenderling, Jens

(57) **Zusammenfassung**

Anordnung (1) umfassend:
- ein Substrat (2) mit einer elektrisch isolierenden Oberfläche (15),
- ein unmittelbar oder mittelbar auf der Oberfläche (15) des Substrats (2) aufliegendes Halbleiterelement (3),
- ein Verbindungselement (4) mit einer ersten elektrisch leitenden Schicht (5), einer elektrisch isolierenden Schicht (6) und einer zweiten elektrisch leitenden

Schicht (7), welche in der angegebenen Reihenfolge aneinander anliegen, wobei das Halbleiterelement (3) durch das Verbindungselement (4) über mindestens eine elektrisch leitende Verbindung (9) an das Substrat (2) angebunden ist.

## Beschreibung

Die Erfindung betrifft eine Anordnung, welche ein Substrat und ein daran angebundenes Halbleiterelement umfasst. Die Erfindung gehört zum technischen Gebiet der Herstellung elektronischer Bauteile. Insbesondere betrifft die Erfindung die Art und Weise, wie elektrische Verbindungen zwischen Kontakten auf dem Halbleiterelement und dem Substrat ausgebildet werden können.

In vielen Anwendungen aus dem Bereich der Elektronik sind Halbleiterelemente mit einem Substrat verbunden. Solche Halbleiterelement können Dioden, Transistoren, oder Computerchips sein. Derartige Halbleiterelemente sind in der Regel an ihrer Unterseite mit dem Substrat verbunden. Darüber hinaus ist es in vielen Anwendungen gewünscht, Kontakte auf der Oberseite des Halbleiterelements mit Kontakten auf dem Substrat zu verbinden. Dies wird auch als Top-Kontaktierung bezeichnet.

Aus dem Stand der Technik sind verschiedene Möglichkeiten bekannt, solche Top-Kontaktierungen auszubilden. Die am weitesten verbreitete Methode ist das Draht-Bonden. Dabei wird ein Draht aus Aluminium, Gold oder Kupfer einerseits mit dem Kontakt auf der Oberseite des Halbleiterelements und andererseits mit dem Kontakt auf dem Substrat verbunden. Das Draht-Bonden hat allerdings die folgenden Nachteile. Die Drähte sind zumeist aus Aluminium und können daher nur begrenz Strom führen. Somit kann eine Mehrzahl von Drähten erforderlich sein, um eine einzelne Verbindung auszubilden. Die mittels Draht-Bonden kontaktierte Kontaktfläche ist in der Regel deutlich kleiner als der Kontakt auf dem Substrat. Es wird also nur ein kleiner teil der zur Verfügung stehenden Fläche des Kontakts tatsächlich als Kontaktfläche genutzt. Das ergibt sich daraus, dass ein Draht-Bond nur mit begrenzter Genauigkeit gesetzt werden kann. Die vergleichsweise kleine Kontaktfläche bewirkt allerdings einen ungewünscht großen elektrischen Widerstand. Eine insoweit vorteilhaftere größere Kontaktfläche wäre nur mit einem entsprechend größeren Kontakt auf dem Substrat möglich, was meist aus Platzgründen nicht oder nur schwer möglich ist. Da die Drähte beim Draht-Bonden in einem "Loop" geführt sind, entsteht zudem eine Induktivität. Diese kann sich nachteilig auf das Schaltverhalten des Halbleiterelements auswirken. Das Draht-Bonden ist zudem immer ein zusätzlicher Prozessschritt, der nach dem Aufbringen des Halbleiterelements auf das Substrat (dem sog. Die-Attach) durchgeführt werden muss. Da in der Regel jeder Draht-Bond einzeln gesetzt wird, ist dieser Prozess aufwendig. Außerdem hat sich in Lebensdauertests gezeigt, dass Draht-Bonds oft das zuerst ausfallende Element eines elektronischen Bauteils sind. Draht-bond-Verbindungen stellen in aktuellen Systemen also die Schwachstelle dar: sie versagen in der Regel als Erstes.

Aufgabe der vorliegenden Erfindung ist es, auf einfache Weise eine besonders langlebige Verbindung zwischen einem Kontakt auf einer Oberseite eines Halbleiterelements und einem Kontakt auf einem Substrat zu erhalten, welche zudem besonders gute elektrische Eigenschaften hat.

Diese Aufgaben werden gelöst mit der Anordnung und dem Verfahren gemäß den unabhängigen Ansprüchen. Weitere vorteilhafte Ausgestaltungen sind in den abhängigen Ansprüchen angegeben. Die in den Ansprüchen und in der Beschreibung dargestellten Merkmale sind in beliebiger, technologisch sinnvoller Weise miteinander kombinierbar.
Erfindungsgemäß wird eine Anordnung vorgestellt, welche umfasst:
- ein Substrat mit einer elektrisch isolierenden Oberfläche,
- ein unmittelbar oder mittelbar auf der Oberfläche des Substrats aufliegendes Halbleiterelement,
- ein Verbindungselement mit einer ersten elektrisch leitenden Schicht, einer elektrisch isolierenden Schicht und einer zweiten elektrisch leitenden Schicht, welche in der angegebenen Reihenfolge aneinander anliegen,
wobei das Halbleiterelement durch das Verbindungselement über mindestens eine elektrisch leitende Verbindung an das Substrat angebunden ist, wobei die elektrisch leitende Verbindung einen Oberseitenkontakt auf einer Oberseite des Halbleiterelements mit einem ersten Kontakt auf der Oberfläche des Substrats verbindet, indem der Oberseitenkontakt und der erste Kontakt über eine jeweilige Vielzahl von Nanodrähten mit der ersten elektrisch leitenden Schicht verbunden sind, wobei die erste elektrisch leitende Schicht zwischen dem Oberseitenkontakt und dem ersten Kontakt durch eine Unterbrechung unterbrochen ist, und wobei die erste elektrisch leitende Schicht beidseits der Unterbrechung jeweils elektrisch leitend durch die elektrisch isolierende Schicht hindurch mit der zweiten elektrisch leitenden Schicht verbunden ist.

Die Anordnung umfasst ein Substrat mit einer elektrisch leitenden Oberfläche. Das Substrat ist vorzugsweise aus einem Halbleitermaterial gebildet, beispielsweise aus Silizium. Das Substrat kann elektrisch isolierend sein. Für die Funktionsweise der beschriebenen Anordnung genügt es allerdings, dass die Oberfläche des Substrats elektrisch isolierend ist. Insoweit sind Kontakte auf der Oberfläche des Substrats elektrisch voneinander isoliert.

Die Anordnung weist weiterhin ein unmittelbar oder mittelbar auf der Oberfläche des Substrats aufliegendes Halbleiterelement auf. Das Halbleiterelement ist vorzugsweise ein elektronisches Bauteil. Beispielsweise kann das Halbleiterelement eine Diode, ein Transistor wie z. B. ein MOSFET oder IGBT (Insulated Gate Bipolar Transistor) oder ein Computerchip wie z.B. ein Computerprozessor sein. Die Funktionsweise der beschriebenen Anordnung kann mit jedem Halbleiterelement erreicht werden, welches insbesondere über die Oberseite kontaktiert wird.

Das Halbleiterelement kann mittelbar oder unmittelbar auf der Oberfläche des Substrats aufliegen. Dies bezieht sich auf die zuvor beschriebene elektrisch isolierende Oberfläche des Substrats. Das Halbleiterelement liegt unmittelbar auf der Oberfläche auf, wenn das Halbleiterelement die Oberfläche des Substrats berührt. In dem Fall ist kein weiteres Element zwischen dem Halbleiterelement und der Oberfläche des Substrats angeordnet. Das Halbleiterelement liegt mittelbar über ein Zwischenelement auf der Oberfläche des Substrats auf, wenn das Halbleiterelement eine Seite des Zwischenelements des Substrats berührt und die Oberfläche des Substrats eine zweite Seite des Zwischenelements berührt. Das Halbleiterelement kann auf analoge Weise auch über etwas anderes als ein einzelnes Zwischenelement mittelbar auf der Oberfläche des Substrats aufliegen, beispielsweise über mehrere Zwischenelemente. Insbesondere kann das Halbleiterelement derart mittelbar auf der Oberfläche des Substrats aufliegen, dass das Halbleiterelement an einer Unterseite elektrisch leitend mit dem Substrat verbunden ist.

Die Anordnung weist weiterhin ein Verbindungselement auf. Das Verbindungselement weist eine erste elektrisch leitende Schicht, eine elektrisch isolierende Schicht und eine zweite elektrisch leitende Schicht auf. Diese drei Schichten liegen in der angegebenen Reihenfolge aneinander an. Das bedeutet, dass die erste elektrisch leitende Schicht an einer ersten Seite der elektrisch isolierenden Schicht an der elektrisch isolierenden Schicht anliegt und die zweite elektrisch leitende Schicht an einer der ersten Seite gegenüberliegenden zweiten Seite der elektrisch isolierenden Schicht an der elektrisch isolierenden Schicht anliegt. Die elektrisch isolierende Schicht befindet sich also zwischen der ersten elektrisch leitenden Schicht und der zweiten elektrisch leitenden Schicht. Die erste Seite der elektrisch isolierenden Schicht ist der Oberfläche des Substrats, zugewandt, die zweite Seite der elektrisch isolierenden Schicht ist vom Substrat abgewandt.

Das Verbindungselement ist vorzugsweise als eine Folie ausgebildet. Anstelle des Begriffs Verbindungselement kann in dem Fall auch der Begriff "mehrschichtige Verbindungsfolie" verwendet werden. Die Schichten können auch als Lagen bezeichnet werden. Insoweit kann das Verbindungselement auch als "mehrlagige Verbindungsfolie" bezeichnet werden. Insbesondere ist es bevorzugt, dass das Verbindungselement flexibel ausgebildet ist. Es ist aber auch nicht ausgeschlossen, dass das Verbindungselement starr ausgebildet ist.

Das Halbleiterelement ist durch das Verbindungselement über mindestens eine elektrisch leitende Verbindung an das Substrat angebunden. Das Verbindungselement dient also dazu, die mindestens eine elektrisch leitende Verbindung auszubilden. Durch das eine Verbindungselement können mehrere der elektrische leitenden Verbindungen ausgebildet sein.

Das Verbindungselement liegt vorzugsweise mittelbar auf der Oberseite des Halbleiterelements auf und in einem oder mehreren von dem Halbleiterelement seitlich beabstandeten Bereichen mittelbar auf der Oberfläche des Substrats auf. Das Halbleiterelement ist also zwischen dem Verbindungselement und der Oberfläche des Substrats angeordnet. So kann ein Kontakt auf der Oberseite des Halbleiterelements mit einem Kontakt auf der Oberfläche des Substrats verbunden werden. Um die einzelnen Kontakte sprachlich voneinander unterscheiden zu können, wird der Kontakt auf der Oberseite des Halbleiterelements als ein Oberseitenkontakt bezeichnet und der Kontakt auf der Oberfläche des Substrats als ein erster Kontakt.

Die elektrisch leitende Verbindung verbindet den Oberseitenkontakt auf der Oberseite des Halbleiterelements mit dem ersten Kontakt auf der Oberfläche des Substrats, indem der Oberseitenkontakt und der erste Kontakt über eine jeweilige Vielzahl von Nanodrähten mit der ersten elektrisch leitenden Schicht verbunden sind, wobei die erste elektrisch leitende Schicht zwischen dem Oberseitenkontakt und dem ersten Kontakt durch eine Unterbrechung unterbrochen ist, und wobei die erste elektrisch leitende Schicht beidseits der Unterbrechung jeweils elektrisch leitend durch die elektrisch isolierende Schicht hindurch mit der zweiten elektrisch leitenden Schicht verbunden ist.

Es gibt also einen Leitungspfad vom ersten Kontakt über eine erste Vielzahl von Nanodrähten zu einem ersten Abschnitt der ersten elektrisch leitenden Schicht, über eine erste Durchkontaktierung durch die elektrisch isolierende Schicht zur zweiten elektrisch leitenden Schicht, entlang der zweiten elektrisch leitenden Schicht, durch eine zweite Durchkontaktierung durch die elektrisch isolierende Schicht zu einem zweiten Abschnitt der ersten elektrisch leitenden Schicht, über eine zweite Vielzahl von Nanodrähten zum Oberseitenkontakt. Dass die erste elektrisch leitende Schicht eine Unterbrechung aufweist, impliziert, dass die erste elektrisch leitende Schicht einen ersten Abschnitt und einen zweiten Abschnitt aufweist, welche voneinander getrennt sind. Durch diese Unterbrechung kann kein Leitungspfad ohne den Umweg über die zweite elektrisch leitende Schicht ausgebildet sein.

Der Oberseitenkontakt und der erste Kontakt sind also über eine jeweilige Vielzahl von Nanodrähten mit einem jeweiligen Abschnitt der ersten elektrisch leitenden Schicht verbunden. Das bedeutet, dass der erste Kontakt über eine erste Vielzahl von Nanodrähten mit einem ersten Abschnitt der ersten elektrisch leitenden Schicht verbunden ist und der Oberseitenkontakt über eine zweite Vielzahl von Nanodrähten mit einem zweiten Abschnitt der ersten elektrisch leitenden Schicht verbunden ist. Der erste Abschnitt und der zweite Abschnitt der elektrisch leitenden Schicht sind durch die Unterbrechung der ersten elektrisch leitenden Schicht voneinander getrennt. Insoweit sind der erste Abschnitt und der zweite Abschnitt der elektrisch leitenden Schicht durch die Unterbrechung der ersten elektrisch leitenden Schicht elektrisch voneinander isoliert.

Dass die erste elektrisch leitende Schicht beidseits der Unterbrechung jeweils elektrisch leitend durch die elektrisch isolierende Schicht hindurch mit der zweiten elektrisch leitenden Schicht verbunden ist, bedeutet, dass der erste Abschnitt der ersten elektrisch leitenden Schicht durch eine erste Durchkontaktierung durch die elektrisch isolierende Schicht hindurch mit der zweiten elektrisch leitenden Schicht verbunden ist und dass der zweite Abschnitt der ersten elektrisch leitenden Schicht durch eine zweite Durchkontaktierung durch die elektrisch isolierende Schicht hindurch mit der zweiten elektrisch leitenden Schicht verbunden ist. Die Durchkontaktierung kann insbesondere über Vias ausgebildet sein. Die zweite elektrisch leitende Schicht ist zwischen der ersten Durchkontaktierung und der zweiten Durchkontaktierung durchgehend ausgebildet. Die zweite elektrisch leitende Schicht verbindet also dies erste Durchkontaktierung elektrisch leitend mit der zweiten Durchkontaktierung. Das ist bereits dadurch impliziert, dass die elektrisch leitende Verbindung den Oberseitenkontakt mit dem ersten Kontakt verbindet.

Die Verbindung zwischen ersten Kontakt auf dem Substrat und dem ersten Abschnitt der ersten elektrisch leitenden Schicht sowie die Verbindung zwischen dem Oberseitenkontakt auf dem Halbleiterelement und dem zweiten Abschnitt der ersten elektrisch leitenden Schicht ist über eine jeweilige Vielzahl von Nanodrähten ausgebildet. Unter einem Nanodraht (engl."nanowire") wird hier jeder materielle Körper verstanden, der eine drahtähnliche Form und eine Größe im Bereich von wenigen Nanometern bis zu wenigen Mikrometern hat. Ein Nanodraht kann z.B. eine kreisförmige, ovale oder mehreckige Grundfläche aufweisen. Insbesondere kann ein Nanodraht eine hexagonale Grundfläche aufweisen.

Vorzugsweise sind alle Nanodrähte aus dem gleichen Material gebildet. Besonders bevorzugt ist es, dass die Nanodrähte aus dem gleichen Material gebildet sind wie die jeweils über die Nanodrähte angebundenen Kontakte. Dass die Nanodrähte an der elektrisch leitenden Verbindung beteiligt sind, impliziert, dass die Nanodrähte elektrisch leitend sind. Besonders bevorzugt sind die Nanodrähte aus Kupfer gebildet.

Bevorzugt weisen die Nanodrähte eine Länge im Bereich von 100 nm [Nanometer] bis 100 µm [Mikrometer], insbesondere im Bereich von 500 nm bis 60 µm auf. Weiterhin weisen die Nanodrähte bevorzugt einen Durchmesser im Bereich von 10 nm bis 10 µm, insbesondere im Bereich von 30 nm bis 2 µm auf. Dabei bezieht sich der Begriff Durchmesser auf eine kreisförmige Grundfläche, wobei bei einer davon abweichenden Grundfläche eine vergleichbare Definition eines Durchmessers heranzuziehen ist. Es ist besonders bevorzugt, dass alle verwendeten Nanodrähte die gleiche Länge und den gleichen Durchmesser aufweisen.

Die Nanodrähte stehen vorzugsweise senkrecht zu den jeweils über die Nanodrähte angebundenen Kontakten.

Das Halbleiterelement kann durch das Verbindungselement über eine oder mehre elektrisch leitende Verbindung(en) an das Substrat angebunden sein. Im Falle mehrerer elektrisch leitender Verbindungen verbindet jede der elektrisch leitenden Verbindungen jeweils einen Oberseitenkontakt auf einer Oberseite des Halbleiterelements mit einem ersten Kontakt auf der Oberfläche des Substrats, indem der jeweilige Oberseitenkontakt und der jeweilige erste Kontakt jeweils über eine jeweilige Vielzahl von Nanodrähten mit der ersten elektrisch leitenden Schicht verbunden sind, wobei die erste elektrisch leitende Schicht zwischen dem jeweiligen Oberseitenkontakt und dem jeweiligen ersten Kontakt durch eine jeweilige Unterbrechung unterbrochen ist, und wobei die erste elektrisch leitende Schicht jeweils beidseits der Unterbrechung elektrisch leitend durch die elektrisch isolierende Schicht hindurch mit der zweiten elektrisch leitenden Schicht verbunden ist.

Pro elektrisch leitender Verbindung gibt es zumindest einen Oberseitenkontakt und zumindest einen ersten Kontakt. Vorzugsweise gibt es pro elektrisch leitender Verbindung genau einen Oberseitenkontakt und genau einen ersten Kontakt. Pro elektrisch leitender Verbindung gibt es also in dem Fall einen Leitungspfad von dem jeweiligen ersten Kontakt über eine jeweilige erste Vielzahl von Nanodrähten zu einem jeweiligen ersten Abschnitt der ersten elektrisch leitenden Schicht, über eine jeweilige erste Durchkontaktierung durch die elektrisch isolierende Schicht zu einem jeweiligen Teil der zweiten elektrisch leitenden Schicht, entlang des jeweiligen Teils der zweiten elektrisch leitenden Schicht, durch eine jeweilige zweite Durchkontaktierung durch die elektrisch isolierende Schicht zu einem jeweiligen zweiten Abschnitt der ersten elektrisch leitenden Schicht, über eine jeweilige zweite Vielzahl von Nanodrähten zum jeweiligen Oberseitenkontakt.

Denkbar ist aber auch, dass an einer elektrisch leitenden Verbindung mehrere Oberseitenkontakte und/oder mehrere erste Kontakte beteiligt sind. In dem Fall sind diese mehreren Oberseitenkontakte durch die elektrisch leitende Verbindung auch untereinander elektrisch leitend verbunden und/oder sind diese mehreren ersten Kontakte durch die elektrisch leitende Verbindung auch untereinander elektrisch leitend verbunden. Also sind diese mehreren Oberseitenkontakte auf dem gleichen elektrischen Potential und/oder sind diese mehreren ersten Kontakte auf dem gleichen elektrischen Potential. Eine solche Ausgestaltung dient also in erster Linie der Redundanz.

In dieser Beschreibung wird in erster Linie davon ausgegangen, dass es pro elektrisch leitender Verbindung genau einen Oberseitenkontakt und genau einen ersten Kontakt gibt. Entsprechende Aussagen gelten aber jeweils auch für den Fall, dass an einer elektrisch leitenden Verbindung mehrere Oberseitenkontakte und/oder mehrere erste Kontakte beteiligt sind.

Pro elektrisch leitender Verbindung hat die erste elektrisch leitende Schicht vorzugsweise genau einen ersten Abschnitt und genau einen zweiten Abschnitt. Pro elektrisch leitender Verbindung hat die zweite elektrisch leitende Schicht vorzugsweise einen jeweiligen Teil. Über diesen ist die jeweilige erste Durchkontaktierung mit der jeweiligen zweiten Durchkontaktierung elektrisch leitend verbunden. Der Begriff "Teil" wird hier verwendet, um eine sprachliche Unterscheidung zum Begriff "Abschnitt" zu schaffen, welcher im Kontext der ersten elektrisch leitenden Schicht verwendet wird. Der an einer der elektrisch leitenden Verbindungen beteiligte erste Abschnitt der ersten elektrisch leitenden Schicht und der zugehörige zweite Abschnitt der ersten elektrisch leitenden Schicht können zusammen als ein Teil der ersten elektrisch leitenden Schicht aufgefasst werden. Pro elektrisch leitender Verbindung gibt es also genau einen Teil der ersten elektrisch leitenden Schicht und genau einen zweiten Teil der elektrisch leitenden Schicht. Über die elektrisch isolierende Schicht sind die Teile der elektrisch leitenden Schichten miteinander verbunden.

Die Teile der ersten elektrisch leitenden Schicht sind vorzugsweise voneinander getrennt, insbesondere durch eine Unterbrechung der ersten elektrisch leitenden Schicht. Die Teile der zweiten elektrisch leitenden Schicht sind vorzugsweise voneinander getrennt, insbesondere durch eine Unterbrechung der zweiten elektrisch leitenden Schicht. So sind die elektrisch leitenden Verbindungen unabhängig voneinander. Die elektrisch leitenden Verbindungen haben lediglich gemeinsam, dass sie alle durch das eine Verbindungselement gebildet sind.

Es ist allerdings nicht ausgeschlossen, dass zwei oder mehr der elektrisch leitenden Verbindungen elektrisch leitend miteinander verbunden sind, beispielsweise indem die jeweiligen Teile der zweiten elektrisch leitenden Schicht elektrisch leitend miteinander in Kontakt stehen oder gar nicht voneinander getrennt sind. Im letzteren Fall könnte auch auf eine sprachliche Unterscheidung der entsprechenden Teile der zweiten elektrisch leitenden Schicht verzichtet werden.

Durch das Verbindungselement kann der Oberseitenkontakt auf der Oberseite des Halbleiterelements auf besonders einfache Weise mit dem ersten Kontakt auf der Oberfläche des Substrats verbunden werden. Sofern mehrere Oberseitenkontakte mit einem jeweiligen ersten Kontakt verbunden werden sollen, können diese mehreren elektrisch leitenden Verbindungen gemeinsam über das eine Verbindungselement ausgebildet werden. Beispielswiese im Vergleich zum Draht-Bonden spart dies Zeit, insbesondere falls eine große Anzahl derartiger elektrisch leitender Verbindungen auszubilden ist.

Die elektrisch leitende Verbindung kann insbesondere aufgrund der Verwendung der Nanodrähte besonders leicht ausgebildet werden. Die Nanodrähte können sich ohne großen Druck und ohne hohe Temperatur mit dem jeweiligen Kontakt verbinden. Das ist insbesondere im Falle eines temperaturempfindlichen Halbleiterelements vorteilhaft.

Weiterhin hat sich herausgestellt, dass die Verwendung der Nanodrähte besonders langlebig ist. Das liegt insbesondere daran, dass die Anbindung der Nanodrähte an die jeweiligen Kontakte auf atomarer Ebene erfolgt. Diese Anbindung kann insbesondere Luftdicht sein, so dass es zu keiner Korrosion kommt.

Darüber hinaus hat die mindestens eine elektrisch leitende Verbindung der beschriebenen Anordnung besonders gute elektrische Eigenschaften. Dies hat mehrere Gründe.

Einerseits kann die mindestens eine elektrisch leitende Verbindung einen besonders kleinen elektrischen Widerstand haben. Dadurch geht entsprechend wenig Energie verloren. Durch Nanodrähte kann allgemein eine besonders gut elektrisch leitende Verbindung zwischen zwei Kontakten erhalten werden. Das liegt an der vergleichsweise großen Kontaktfläche, welche aufgrund der Anzahl der Nanodrähte in Summe entsteht. Elektrische Widerstände an Materialübergängen sind vergleichsweise klein. Zudem kann über die Nanodrähte auf einfache Weise eine vergleichsweise große Fläche eines Kontakts angebunden werden. Dazu trägt bei, dass das Verbindungselement leichter präzise zu platzieren ist als beispielsweise ein Draht-Bond. Der Kontakt muss also nicht viel größer sein als die letztlich für die Verbindung genutzte Kontaktfläche, wie dies etwa beim Draht-Bonden der Fall ist.

Andererseits kann durch die Ausgestaltung des Verbindungselements eine besonders geringe Induktivität erreicht werden, wodurch die Arbeitsfrequenz erhöht werden kann. Das liegt insbesondere daran, dass der Leitungspfad vom Oberseitenkontakt zum entsprechenden ersten Kontakt über den Umweg der zweiten elektrisch leitenden Schicht führt. Dies hängt damit zusammen, dass die erste elektrisch leitende Schicht eine Unterbrechung aufweist. Im Bereich der Unterbrechung ist die elektrisch isolierende Schicht der Oberfläche des Substrats zugewandt. Damit kann das Verbindungselement auch außerhalb des ersten Kontakts auf der Oberfläche des Substrats aufliegen, ohne einen Kurzschluss mit anderen elektrisch leitenden Elementen auf der Oberfläche des Substrats zu verursachen. Das könnte bei einer durchgehenden ersten elektrisch leitenden Schicht der Fall sein. Aufgrund der Ausgestaltung des Verbindungselements muss das Verbindungselement also nicht wie beispielsweise ein Draht-Bond in einem Loop geführt werden, um sicherzustellen, dass es zu keinem Kurzschluss kommt. Das Verbindungselement kann vielmehr flach ausgebildet sein, woraus sich eine geringere Induktivität ergibt als bei einem Loop. Besonders bevorzugt schmiegt sich das Verbindungselement an das Substrat und das Halbleiterelement an.

Dass die Ausgestaltung des Verbindungselements einen Kurzschluss verhindern kann, ist auch dann von Vorteil, wenn das Verbindungselement tatsächlich nicht außerhalb des ersten Kontakts auf der Oberfläche des Substrats aufliegt. Der Vorteil besteht bereits darin, dass die Ausgestaltung des Verbindungselements die Gefahr eines Kurzschlusses verhindert, welcher eintreten könnte, sobald das Verbindungselement außerhalb des ersten Kontakts mit der Oberfläche in Kontakt gelangen würde.

Über das Verbindungselement kann auch eine thermische Leitung erfolgen. Auch dies ist aufgrund der beschriebenen Ausgestaltung des Verbindungselements besonders gut möglich. So kann über das Verbindungselement Wärme vom Halbleiterelement abgeleitet werden.

In einer bevorzugten Ausführungsform der Anordnung weist das Substrat weiterhin an der Oberfläche einen zweiten Kontakt auf, wobei das Halbleiterelement an einer Unterseite einen Unterseitenkontakt aufweist, und wobei der Unterseitenkontakt des Halbleiterelements über eine weitere Vielzahl von Nanodrähten mit dem zweiten Kontakt verbunden ist.

In der vorliegenden Ausführungsform ist das Halbleiterelement nicht nur über die Oberseite kontaktiert, sondern auch über die Unterseite. Letzteres kann auch als ein Bottom-Kontaktierung bezeichnet werden.

Die Verbindung zwischen dem Unterseitenkontakt und dem zweiten Kontakt ist über eine weitere Vielzahl von Nanodrähten ausgebildet. Für diese Nanodrahtverbindung gilt das zuvor Gesagte entsprechend, insbesondere zur Ausgestaltung der Nanodrähte und zu den durch die Nanodrähte erzielten Vorteilen.

Alternativ zur vorliegenden Ausführungsform kann das Halbleiterelement durch eine beliebige andere Verbindungsmethode mit dem Substrat verbunden sein. Im einfachsten Fall ist das Halbleiterelement auf das Substrat geklebt. Ist diese Klebeverbindung elektrisch isolierend, ist das Halbleiterelement nicht über seine Unterseite kontaktiert. Allerdings gibt es auch zahlreiche Möglichkeiten, das Halbleiterelement alternativ zu Nanodrähten über die Unterseite zu kontaktieren. Beispielsweise kann das Substrat an der Oberfläche einen zweiten Kontakt aufweisen, wobei das Halbleiterelement an einer Unterseite einen Unterseitenkontakt aufweist, und wobei der Unterseitenkontakt des Halbleiterelements durch eine Lotverbindung, eine Schweißverbindung oder über einen elektrisch leitenden Klebstoff mit dem zweiten Kontakt verbunden ist.

In einer weiteren bevorzugten Ausführungsform der Anordnung ist das Verbindungselement ein Flexible-Printed-Circuit-Board, FPCB.

In einer weiteren bevorzugten Ausführungsform der Anordnung ist die erste elektrisch leitende Schicht aus Kupfer gebildet und/oder ist die elektrisch isolierende Schicht aus einem Kunststoff gebildet und/oder ist die zweite elektrisch leitende Schicht aus Kupfer gebildet. Der"und"-Fall ist jeweils bevorzugt.

Beispielsweise kann die elektrisch isolierende Schicht des Verbindungselements aus einem Polymer gebildet sein, insbesondere aus Polyimid. Die Verwendung von Kupfer als Material für die elektrisch leitenden Schichten ist insbesondere aufgrund der guten elektrischen und thermischen Leitfähigkeit von Kupfer vorteilhaft.

In einer weiteren bevorzugten Ausführungsform der Anordnung ist das Halbleiterelement durch das Verbindungselement über mehrere der elektrisch leitenden Verbindungen an das Substrat angebunden.

In einer weiteren bevorzugten Ausführungsform der Anordnung ist ein Zwischenraum zwischen dem Verbindungselement und dem Substrat zumindest teilweise mit einem elektrisch isolierenden Füllmaterial gefüllt.

Das elektrisch isolierende Füllmaterial kann die Gefahr eines Kurzschlusses, insbesondere eine Hochfrequenzentladung, weiter reduzieren. So kann das elektrisch isolierende Füllmaterial das Eindringen von Luft in den Zwischenraum verhindern. Damit kann ein elektrischer Durchschlag über eine Luftbrücke verhindert werden. Das elektrisch isolierende Füllmaterial kann somit besonders geringe Kontaktabstände ermöglichen. Das Eindringen von Luft kann weiter dadurch erschwert werden, dass das Verbindungselement unter Vakuum mit dem Substrat und dem Halbleiterelement verbunden wird.

Vorzugsweise ist der Zwischenraum vollständig mit dem elektrisch isolierenden Füllmaterial gefüllt. In dem Fall können die beschriebenen Effekte im maximalen Umfang erzielt werden. In geringerem Umfang können diese Effekte aber bereits erzielt werden, wenn der Zwischenraum nur teilweise mit dem elektrisch isolierenden Füllmaterial gefüllt ist.

Zudem kann das Füllmaterial die mechanische Stabilität der Anordnung verbessern und insoweit zur Langlebigkeit der Anordnung beitragen. Das Füllmaterial kann ein Klebstoff sein. Insbesondere in dem Fall kann das Füllmaterial zur mechanischen Stabilität beitragen.

Gibt es mehrere voneinander getrennte Zwischenräume zwischen dem Verbindungselement und dem Substrat, ist vorzugsweise jeder dieser Zwischenräume zumindest teilweise, insbesondere vollständig, mit einem elektrisch isolierenden Füllmaterial gefüllt.

In einer weiteren bevorzugten Ausführungsform der Anordnung weist das Verbindungselement mindestens einen Entlüftungskanal zum Entlüften eines Zwischenraums zwischen dem Verbindungselement und dem Substrat auf und/oder weist das Substrat mindestens einen Entlüftungskanal zum Entlüften eines Zwischenraums zwischen dem Verbindungselement und dem Substrat auf. Der"und"-Fall ist bevorzugt.

Eine Möglichkeit zur Entlüftung des Zwischenraums zwischen dem Verbindungselement und dem Substrat ist insbesondere in Kombination mit der zuvor beschriebenen Ausführungsform sinnvoll, bei welcher der Zwischenraum zwischen dem Verbindungselement und dem Substrat mit einem elektrisch isolierenden Füllmaterial gefüllt ist. In dem Fall kann das Füllmaterial in den Zwischenraum eingefüllt werden, nachdem das Verbindungselement auf die Oberfläche des Substrats und das Halbleiterelement aufgelegt worden ist. Dies kann beispielsweise über eine Einfüllöffnung im Verbindungselement erfolgen, welche insbesondere nach dem Einfüllen des Füllmaterials verschlossen werden kann. Über den mindestens einen Entlüftungskanal kann die von dem Füllmaterial verdrängte Luft aus dem Zwischenraum entweichen.

Der mindestens eine Entlüftungskanal kann aber auch sinnvoll sein, wenn der Zwischenraums zwischen dem Verbindungselement und dem Substrat nicht mit einem Füllmaterial gefüllt ist. Beispielsweise kann der mindestens eine Entlüftungskanal bewirken, dass ein Luftdruck innerhalb des Zwischenraums auch bei Temperaturschwankungen konstant bleibt. Ohne Entlüftungsmöglichkeit könnte sich in dem Zwischenraum eingeschlossene Luft ausdehnen, wenn die Temperatur ansteigt. Dies könnte das Verbindungselement vom ersten Kontakt oder vom Oberseitenkontakt lösen.

Als ein weiterer Aspekt der Erfindung wird ein Verfahren zur Herstellung einer Anordnung vorgestellt. Das Verfahren umfasst:
a) Bereitstellen eines Substrats mit einer elektrisch isolierenden Oberfläche,
b) Unmittelbares oder mittelbares Auflegen eines Halbleiterelements auf die Oberfläche des Substrats,
c) Bereitstellen eines Verbindungselements mit einer ersten elektrisch leitenden Schicht, einer elektrisch isolierenden Schicht und einer zweiten elektrisch leitenden Schicht, welche in der angegebenen Reihenfolge aneinander anliegen, und
d) Anbinden des Halbleiterelements durch das Verbindungselement über mindestens eine elektrisch leitende Verbindung an das Substrat, wobei die elektrisch leitende Verbindung einen Oberseitenkontakt auf einer Oberseite des Halbleiterelements mit einem ersten Kontakt auf der Oberfläche des Substrats verbindet, indem
   - der erste Kontakt über eine erste Vielzahl von Nanodrähten mit einem ersten Abschnitt der ersten elektrisch leitenden Schicht verbunden wird, indem die erste Vielzahl der Nanodrähte auf dem ersten Kontakt oder auf dem ersten Abschnitt der ersten elektrisch leitenden Schicht bereitgestellt wird, und der erste Kontakt über die erste Vielzahl der Nanodrähte mit dem ersten Abschnitt der ersten elektrisch leitenden Schicht zusammengeführt wird, und
   - der Oberseitenkontakt über eine zweite Vielzahl von Nanodrähten mit einem zweiten Abschnitt der ersten elektrisch leitenden Schicht verbunden wird, indem die zweite Vielzahl der Nanodrähte auf dem Oberseitenkontakt oder auf dem zweiten Abschnitt der ersten elektrisch leitenden Schicht bereitgestellt wird, und der Oberseitenkontakt über die zweite Vielzahl der Nanodrähte mit dem zweiten Abschnitt der ersten elektrisch leitenden Schicht zusammengeführt wird,
wobei die erste elektrisch leitende Schicht zwischen dem ersten Abschnitt und dem zweiten Abschnitt durch eine Unterbrechung unterbrochen ist, und wobei die erste elektrisch leitende Schicht beidseits der Unterbrechung jeweils elektrisch leitend durch die elektrisch isolierende Schicht hindurch mit der zweiten elektrisch leitenden Schicht verbunden ist.

Die beschriebenen Vorteile und Merkmale der Anordnung sind auf das Verfahren anwendbar und übertragbar, und umgekehrt. Die Anordnung ist vorzugsweise durch das Verfahren hergestellt. Das Verfahren ist vorzugsweise zur Herstellung der beschriebenen Anordnung ausgebildet.

Die Schritte a) bis d) können grundsätzlich in beliebiger Reihenfolge durchgeführt werden. Allerdings baut Schritt b) auf Schritt a) auf und baut Schritt d) auf den Schritten b) und c) und über Schritt b) auch auf Schritt a) auf. Dies impliziert, dass Schritt b) nach Schritt a) durchgeführt wird und Schritt d) nach den Schritten a), b) und c).

In Schritt b) kann das Halbleiterelement insbesondere insoweit mittelbar auf die Oberfläche des Substrats aufgelegt werden, als dass das Halbleiterelement über einen Unterseitenkontakt des Halbleiterelements durch eine weitere Vielzahl von Nanodrähten mit einem zweiten Kontakt auf der Oberfläche des Substrats verbunden wird.

In Schritt d) wird das Halbleiterelement durch das Verbindungselement über die mindestens eine elektrisch leitende Verbindung an das Substrat angebunden. Dazu werden mehrere Kontakte über eine jeweilige Vielzahl von Nanodrähten miteinander verbunden. Pro elektrisch leitender Verbindung wird jeweils ein erster Kontakt mit einem ersten Abschnitt der ersten elektrisch leitenden Schicht des Verbindungselements verbunden und ein Oberseitenkontakt des Halbleiterelements mit einem zweiten Abschnitt der ersten elektrisch leitenden Schicht des Verbindungselements. Pro elektrisch leitender Verbindung werden also jeweils zwei Nanodrahtverbindungen ausgebildet.

Allgemein können zwei Elemente wie Kontakte auf verschiedene Arten über eine Vielzahl von Nanodrähten miteinander verbunden werden. Allen diesen Arten ist gemein, dass die Verbindung aufgrund der Anzahl der Nanodrähte über eine vergleichsweise große Fläche ausgebildet wird. Die dabei wirkenden Einzelkräfte summieren sich so zu einer vergleichsweise großen Gesamtkraft auf.

Bei dem beschriebenen Verfahren können die einzelnen Nanodrahtverbindungen jeweils durch eine der folgenden Methoden ausgebildet werden. Vorzugsweise werden der Einfachheit halber alle Nanodrahtverbindungen mit der gleichen Methode ausgebildet. Es ist aber auch möglich, für die Nanodrahtverbindungen verschiedene Methoden zu verwenden.

In einer ersten Methode werden die Nanodrähte nur auf einem der zu verbindenden Elemente bereitgestellt. Das kann insbesondere durch galvanisches Wachstum erfolgen. Die Nanodrähte werden anschließend mit dem anderen zu verbinden Element in Kontakt gebracht. Damit können die beiden Elemente bereits miteinander verbunden sein. Das gilt umso mehr, wenn die beiden Elemente temporär mit einem Druck zusammengepresst werden. Um die Verbindung zu stärken, werden die beiden Elemente und die Nanodrähte erwärmt, beispielsweise für eine Zeit zwischen 1 und 10 min auf eine Temperatur im Bereich von 90 bis 300 °C, vorzugsweise für eine Zeit von 2 min auf eine Temperatur von 170 °C. Eine solche Erwärmung erfolgt kürzer und/oder auf eine niedrigere Temperatur als dies bei alternativen Verfahren aus dem Stand der Technik der Fall ist, insbesondere beim Löten oder Silbersintern. Insoweit können die Elemente durch die Nanodrähte besonders schonend miteinander verbunden werden. Durch die beschriebene Erwärmung können sich die Nanodrähte auf dem einen Element mit der Oberfläche des anderen Elements verbinden. Dabei entsteht eine Verbindung auf atomarer Ebene. Der dabei ablaufende Prozess ähnelt dem Sintern. Die Lebensdauer einer solchen Verbindung ist daher besonders hoch.

In einer Weiterentwicklung der ersten Methode wird ein Klebstoff zwischen die Nanodrähte eingebracht. Über den Klebstoff werden die beiden Elemente zusätzlich mechanisch miteinander verbunden.

In einer zweiten Methode werden die Nanodrähte auf beiden der zu verbindenden Elemente bereitgestellt. Das kann insbesondere durch galvanisches Wachstum erfolgen. Werden die beiden Elemente zusammengeführt, kommen die Nanodrähte des einen Elements mit den Nanodrähten des anderen Elements in Kontakt. Dabei verhaken die Nanodrähte untereinander. Dadurch entsteht eine Verbindung zwischen den Nanodrähten auf dem einen Element und den Nanodrähten auf dem anderen Element. Aufgrund der Anzahl der Nanodrähte gibt es dabei in Summe eine vergleichsweise große Kontaktfläche zwischen den Nanodrähten. Durch diese ist die erhaltene Verbindung besonders stabil und besonders gut elektrisch leitend. Auch bei der zweiten Methode kann ein Druck ausgeübt werden und/oder kann eine Erwärmung stattfinden. Insbesondere bei der zweiten Methode ist dies aber nicht erforderlich.

Die beschriebene Anordnung kann insbesondere unter Einsatz jeder der beschriebenen Methoden erhalten werden. Es hat sich allerdings herausgestellt, dass die erste Methode besonders gut geeignet ist. Dass die Nanodrähte auf nur einem der zu verbindenden Elemente bereitgestellt werden, erleichtert das Verfahren.

Das beschriebene Verfahren wendet daher die erste Methode an. Die miteinander zu verbindenden Elemente sind dabei jeweils das Paar von erstem Kontakt und erstem Abschnitt der ersten elektrisch leitenden Schicht des Verbindungselements und das Paar von Oberseitenkontakt und zweitem Abschnitt der ersten elektrisch leitenden Schicht des Verbindungselements. Die Elemente dieser Paare werden jeweils miteinander verbunden, indem
- der erste Kontakt über eine erste Vielzahl von Nanodrähten mit einem ersten Abschnitt der ersten elektrisch leitenden Schicht verbunden wird, indem die erste Vielzahl der Nanodrähte auf dem ersten Kontakt oder auf dem ersten Abschnitt der ersten elektrisch leitenden Schicht bereitgestellt wird, und der erste Kontakt über die erste Vielzahl der Nanodrähte mit dem ersten Abschnitt der ersten elektrisch leitenden Schicht zusammengeführt wird, und
- der Oberseitenkontakt über eine zweite Vielzahl von Nanodrähten mit einem zweiten Abschnitt der ersten elektrisch leitenden Schicht verbunden wird, indem die zweite Vielzahl der Nanodrähte auf dem Oberseitenkontakt oder auf dem zweiten Abschnitt der ersten elektrisch leitenden Schicht bereitgestellt wird, und der Oberseitenkontakt über die zweite Vielzahl der Nanodrähte mit der zweiten Abschnitt der ersten elektrisch leitenden Schicht zusammengeführt wird.

Die in den beiden vorstehenden Spiegelstrichen beschriebenen Unterschritte können nacheinander oder gleichzeitig durchgeführt werden. Bevorzugt werden die beiden Unterschritte gleichzeitig durchgeführt, insbesondere gleichzeitig für alle auszubildenden elektrisch leitenden Verbindungen. In dem Fall können durch das Verbindungselement in einem einzigen Schritt alle elektrisch leitenden Verbindungen erhalten werden. Dies bietet insbesondere gegenüber dem Draht-Bonden eine erhebliche Beschleunigung des Herstellprozesses. Insbesondere genügt es, das Verbindungselement ein einziges Mal korrekt zu positionieren. Demgegenüber muss beispielsweise jeder einzelne Draht-Bond einzeln platziert werden.

Vorzugsweise wird die erste Vielzahl der Nanodrähte auf dem ersten Abschnitt der ersten elektrisch leitenden Schicht bereitgestellt und/oder wird die zweite Vielzahl der Nanodrähte auf dem zweiten Abschnitt der ersten elektrisch leitenden Schicht bereitgestellt. Der"und"-Fall ist besonders bevorzugt. Letzteres bedeutet, dass die Nanodrähte nur auf dem Verbindungselement bereitgestellt werden. Das Halbleiterelement kann in dem Fall an das Substrat einfach angebunden werden, indem das entsprechend vorbereitete Verbindungselement auf das Substrat und das Halbleiterelement aufgelegt wird. Optional kann temporär ein Druck ausgeübt werden, mit welchem das Verbindungselement an das Substrat und das Halbleiterelement gedrückt wird. Das Verbindungselement wird in dem Fall verwendet wie ein Klebeband. Die Haftwirkung wird allerdings bei dem Verbindungselement im Unterschied zu einem Klebeband insbesondere über die Nanodrähte erzeugt.

Schritt d) wird vorzugsweise unter Vakuum durchgeführt. So kann verhindert werden, dass Luft zwischen dem Substrat und dem Halbleiterelement einerseits und dem Verbindungselement andererseits eingeschlossen wird. Dies kann alternativ oder zusätzlich dadurch unterstützt werden, dass ein Zwischenraum zwischen dem Verbindungselement und dem Substrat zumindest teilweise mit einem elektrisch isolierenden Füllmaterial gefüllt wird.

In einer bevorzugten Ausführungsform des Verfahrens verbindet die elektrisch leitende Verbindung den Oberseitenkontakt auf der Oberseite des Halbleiterelements mit dem ersten Kontakt auf der Oberfläche des Substrats, indem weiterhin
- zumindest der erste Kontakt und der erste Abschnitt der ersten elektrisch leitenden Schicht auf mindestens 90°C, insbesondere auf mindestens 170°C erhitzt werden, und/oder
- zumindest der Oberseitenkontakt und der zweite Abschnitt der ersten elektrisch leitenden Schicht auf mindestens 90°C, insbesondere auf mindestens 170°C erhitzt werden.

Der"und"-Fall ist bevorzugt. Die Erwärmung kann insbesondere insoweit erfolgen, als dass die gesamte Anordnung in einem Ofen erwärmt wird.

Die Erfindung wird nachfolgend anhand der Figuren näher erläutert. Die Figuren zeigen ein bevorzugtes Ausführungsbeispiel, auf das die Erfindung jedoch nicht begrenzt ist. Die Figuren und die darin dargestellten Größenverhältnisse sind nur schematisch. Es zeigen:

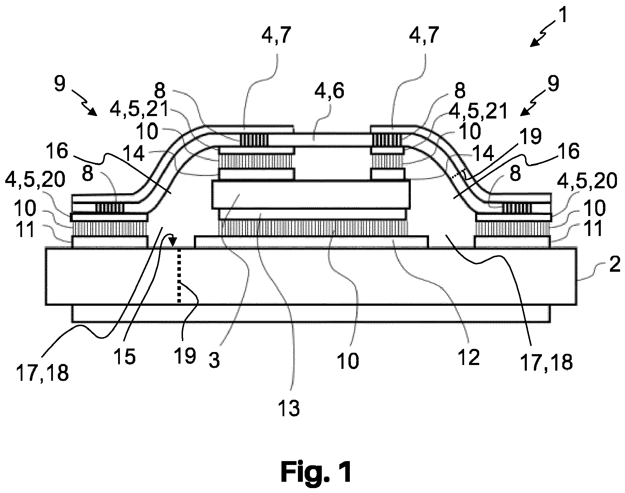

- Fig. 1:: eine erfindungsgemäße Anordnung.

Fig. 1 zeigt eine Anordnung 1. Die Anordnung 1 umfasst ein Substrat 2 mit einer elektrisch isolierenden Oberfläche 15. Weiterhin umfasst die Anordnung 1 ein mittelbar auf der Oberfläche 15 des Substrats 2 aufliegendes Halbleiterelement 3. Zudem weist die Anordnung 1 ein Flexible-Printed-Circuit-Board, FPCB, als ein Verbindungselement 4 auf. Das Verbindungselement 4 ist gebildet aus einer ersten elektrisch leitenden Schicht 5, einer elektrisch isolierenden Schicht 6 und einer zweiten elektrisch leitenden Schicht 7. Die Schichten 5,6,7 liegen in der angegebenen Reihenfolge aneinander an. Die erste elektrisch leitende Schicht 5 und die zweite elektrisch leitende Schicht 7 sind aus Kupfer gebildet. Die elektrisch isolierende Schicht 6 ist aus einem Kunststoff gebildet.

Das Halbleiterelement 3 ist durch das Verbindungselement 4 über zwei elektrisch leitende Verbindungen 9 an das Substrat 2 angebunden. Die gezeigte Anordnung 1 ist also ein Beispiel dafür, dass das Halbleiterelement 3 durch das Verbindungselement 4 über mehrere elektrisch leitende Verbindungen 9 an das Substrat 2 angebunden ist. Die elektrisch leitenden Verbindungen 9 verbinden jeweils einen Oberseitenkontakt 14 auf einer Oberseite des Halbleiterelements 3 mit einem ersten Kontakt 11 auf der Oberfläche 15 des Substrats 2, indem der jeweilige Oberseitenkontakt 14 und der jeweilige erste Kontakt 11 jeweils über eine jeweilige Vielzahl von Nanodrähten 10 mit einem jeweiligen Abschnitt 20,21 der ersten elektrisch leitenden Schicht 5 verbunden sind.

Das Substrat 2 weist an der Oberfläche 15 einen zweiten Kontakt 12 auf und das Halbleiterelement 3 weist an einer Unterseite einen Unterseitenkontakt 13 auf. Der Unterseitenkontakt 13 des Halbleiterelements 3 ist über eine weitere Vielzahl von Nanodrähten 10 mit dem zweiten Kontakt 12 verbunden. Insoweit liegt das Halbleiterelement 3 über den zweiten Kontakt 12 und die Nanodrähte 10 mittelbar auf der Oberfläche 15 des Substrats 2 auf.

Die erste elektrisch leitende Schicht 5 ist für beide elektrisch leitenden Verbindungen 9 jeweils zwischen dem entsprechenden Oberseitenkontakt 14 und dem entsprechenden ersten Kontakt 11 durch eine Unterbrechung 16 unterbrochen. Die erste elektrisch leitende Schicht 5 ist beidseits der Unterbrechungen 16 durch eine jeweilige Durchkontaktierung 8 elektrisch leitend durch die elektrisch isolierende Schicht 6 hindurch mit der zweiten elektrisch leitenden Schicht 7 verbunden.

Ein Zwischenraum 17 zwischen dem Verbindungselement 4 und dem Substrat 2 ist mit einem elektrisch isolierenden Füllmaterial 18 gefüllt. Das Verbindungselement 4 und das Substrat 2 weisen jeweils einen Entlüftungskanal 19 zum Entlüften eines der Zwischenräume 17 auf.

Die Darstellung in Fig. 1 ist zur Verdeutlichung nicht maßstabsgetreu. Insbesondere sind die ersten Kontakte 11, der zweite Kontakt 12, der Unterseitenkontakt 13, die Oberseitenkontakte 14 und das Verbindungselement 4 jeweils mit einer übertriebenen Dicke dargestellt. Die Nanodrähte 10 sind mit einer übertriebenen Länge dargestellt. Aufgrund der gewählten Darstellungsform sind insbesondere die Zwischenräume 17 übertrieben groß dargestellt. Tatsächlich kann sich das Verbindungselement 4 an das Substrat 2 und an das Halbleiterelement 3 anschmiegen.

### Bezugszeichenliste

- 1: Anordnung
- 2: Substrat
- 3: Halbleiterelement
- 4: Verbindungselement
- 5: erste elektrisch leitende Schicht
- 6: elektrisch isolierende Schicht
- 7: zweite elektrisch leitende Schicht
- 8: Durchkontaktierung
- 9: elektrisch leitende Verbindung
- 10: Nanodrähte
- 11: erster Kontakt
- 12: zweiter Kontakt
- 13: Unterseitenkontakt
- 14: Oberseitenkontakt
- 15: Oberfläche
- 16: Unterbrechung
- 17: Zwischenraum
- 18: Füllmaterial
- 19: Entlüftungskanal
- 20: erster Abschnitt
- 21: zweiter Abschnitt

## Patentansprüche

1. Anordnung (1) umfassend:
- ein Substrat (2) mit einer elektrisch isolierenden Oberfläche (15),
- ein unmittelbar oder mittelbar auf der Oberfläche (15) des Substrats (2) aufliegendes Halbleiterelement (3),
- ein Verbindungselement (4) mit einer ersten elektrisch leitenden Schicht (5), einer elektrisch isolierenden Schicht (6) und einer zweiten elektrisch leitenden Schicht (7), welche in der angegebenen Reihenfolge aneinander anliegen, wobei das Halbleiterelement (3) durch das Verbindungselement (4) über mindestens eine elektrisch leitende Verbindung (9) an das Substrat (2) angebunden ist, wobei die elektrisch leitende Verbindung (9) einen Oberseitenkontakt (14) auf einer Oberseite des Halbleiterelements (3) mit einem ersten Kontakt (11) auf der Oberfläche (15) des Substrats (2) verbindet, indem der Oberseitenkontakt (14) und der erste Kontakt (11) über eine jeweilige Vielzahl von Nanodrähten (10) mit der ersten elektrisch leitenden Schicht (5) verbunden sind, wobei die erste elektrisch leitende Schicht (5) zwischen dem Oberseitenkontakt (14) und dem ersten Kontakt (11) durch eine Unterbrechung (16) unterbrochen ist, und wobei die erste elektrisch leitende Schicht (5) beidseits der Unterbrechung (16) jeweils elektrisch leitend durch die elektrisch isolierende Schicht (6) hindurch mit der zweiten elektrisch leitenden Schicht (7) verbunden ist.

2. Anordnung (1) nach Anspruch 1, wobei das Substrat (2) weiterhin an der Oberfläche (15) einen zweiten Kontakt (12) aufweist, wobei das Halbleiterelement (3) an einer Unterseite einen Unterseitenkontakt (13) aufweist, und wobei der Unterseitenkontakt (13) des Halbleiterelements (3) über eine weitere Vielzahl von Nanodrähten (10) mit dem zweiten Kontakt (12) verbunden ist.

3. Anordnung (1) nach einem der vorstehenden Ansprüche, wobei das Verbindungselement (4) ein Flexible-Printed-Circuit-Board, FPCB, ist.

4. Anordnung (1) nach einem der vorstehenden Ansprüche, wobei die erste elektrisch leitende Schicht (5) aus Kupfer gebildet ist und/oder die elektrisch isolierende Schicht (6) aus einem Kunststoff gebildet ist und/oder die zweite elektrisch leitende Schicht (7) aus Kupfer gebildet ist.

5. Anordnung (1) nach einem der vorstehenden Ansprüche, wobei das Halbleiterelement (3) durch das Verbindungselement (4) über mehrere der elektrisch leitenden Verbindungen (9) an das Substrat (2) angebunden ist.

6. Anordnung (1) nach einem der vorstehenden Ansprüche, wobei ein Zwischenraum (17) zwischen dem Verbindungselement (4) und dem Substrat (2) zumindest teilweise mit einem elektrisch isolierenden Füllmaterial (18) gefüllt ist.

7. Anordnung (1) nach einem der vorstehenden Ansprüche, wobei das Verbindungselement (4) mindestens einen Entlüftungskanal (19) zum Entlüften eines Zwischenraums (17) zwischen dem Verbindungselement (4) und dem Substrat (2) aufweist und/oder das Substrat (2) mindestens einen Entlüftungskanal (19) zum Entlüften eines Zwischenraums (17) zwischen dem Verbindungselement (4) und dem Substrat (2) aufweist.

8. Verfahren zur Herstellung einer Anordnung (1), umfassend:
a) Bereitstellen eines Substrats (2) mit einer elektrisch isolierenden Oberfläche (15),
b) Unmittelbares oder mittelbares Auflegen eines Halbleiterelements (3) auf die Oberfläche (15) des Substrats (2),
c) Bereitstellen eines Verbindungselements (4) mit einer ersten elektrisch leitenden Schicht (5), einer elektrisch isolierenden Schicht (6) und einer zweiten elektrisch leitenden Schicht (7), welche in der angegebenen Reihenfolge aneinander anliegen, und
d) Anbinden des Halbleiterelements (3) durch das Verbindungselement (4) über mindestens eine elektrisch leitende Verbindung (9) an das Substrat (2), wobei die elektrisch leitende Verbindung (9) einen Oberseitenkontakt (14) auf einer Oberseite des Halbleiterelements (3) mit einem ersten Kontakt (11) auf der Oberfläche (15) des Substrats (2) verbindet, indem
- der erste Kontakt (11) über eine erste Vielzahl von Nanodrähten (10) mit einem ersten Abschnitt (20) der ersten elektrisch leitenden Schicht (5) verbunden wird, indem die erste Vielzahl der Nanodrähte (10) auf dem ersten Kontakt (11) oder auf dem ersten Abschnitt (20) der ersten elektrisch leitenden Schicht (5) bereitgestellt wird, und der erste Kontakt (11) über die erste Vielzahl der Nanodrähte (10) mit dem ersten Abschnitt (20) der ersten elektrisch leitenden Schicht (5) zusammengeführt wird, und
- der Oberseitenkontakt (14) über eine zweite Vielzahl von Nanodrähten (10) mit einem zweiten Abschnitt (21) der ersten elektrisch leitenden Schicht (5) verbunden wird, indem die zweite Vielzahl der Nanodrähte (10) auf dem Oberseitenkontakt (14) oder auf dem zweiten Abschnitt (21) der ersten elektrisch leitenden Schicht (5) bereitgestellt wird, und der Oberseitenkontakt (14) über die zweite Vielzahl der Nanodrähte (10) mit dem zweiten Abschnitt (21) der ersten elektrisch leitenden Schicht (5) zusammengeführt wird,
wobei die erste elektrisch leitende Schicht (5) zwischen dem ersten Abschnitt (20) und dem zweiten Abschnitt (21) durch eine Unterbrechung (16) unterbrochen ist, und wobei die erste elektrisch leitende Schicht (5) beidseits der Unterbrechung (16) jeweils elektrisch leitend durch die elektrisch isolierende Schicht (6) hindurch mit der zweiten elektrisch leitenden Schicht (7) verbunden ist.

9. Verfahren nach Anspruch 8, wobei die elektrisch leitende Verbindung (9) den Oberseitenkontakt (14) auf der Oberseite des Halbleiterelements (3) mit dem ersten Kontakt (11) auf der Oberfläche (15) des Substrats (2) verbindet, indem weiterhin
- zumindest der erste Kontakt (11) und der erste Abschnitt (20) der ersten elektrisch leitenden Schicht (5) auf mindestens 90°C erhitzt werden, und/oder
- zumindest der Oberseitenkontakt (14) und der zweite Abschnitt (21) der ersten elektrisch leitenden Schicht (5) auf mindestens 90°C erhitzt werden.
